# EUROPÄISCHE PATENTANMELDUNG

(11) **EP 4 685 440 A1**
(43) Veröffentlichungstag der Anmeldung: **28.01.2026**
(21) Anmeldenummer: 24190909.2
(22) Anmeldetag: 25.07.2024
(51) Int. Cl.: G01D 5/353, G01D 5/48, G01K 11/32, G01R 29/08, G01R 33/032, G01K 5/48

(54) **OPTISCHER SENSOR**

(71) Anmelder: Siemens Aktiengesellschaft, 80333 München (DE)
(72) Erfinder: Nerreter, Stefan, 15754 Heidesee OT Blossin (DE); Wetzel, Ulrich, 91325 Adelsdorf (DE); Zettner, Jürgen, 90587 Veitsbronn (DE)
(74) Vertreter: Siemens Patent Attorneys

(57) **Zusammenfassung**

Die Erfindung betrifft einen Sensor und ein Verfahren zur Erfassung einer physikalischen Einflussgröße mit wenigstens einem optischen Sender (TX) und wenigstens einem optischen Empfänger (RX). Des Weiteren betrifft die Erfindung ein Herstellungsverfahren für einen optischen Sensor sowie ein elektrisches Bauteil mit einem optischen Sensor. Der vorgeschlagene Sensor weist wenigstens einen optischen Sender (TX) und wenigstens einen optischen Empfänger (RX) auf, sowie eine Anordnung wenigstens eines optischen Wellenleiters (OF) zwischen optischem Sender (TX) und optischem Empfänger (RX). Der optische Wellenleiter (OF) ist mit einem funktionalen Element auf einem mechanisch auslenkbaren Steg (ST, SE, SM) angeordnet. Das funktionale Element kann ein Bimetall, eine ferroelektrische Beschichtung oder eine magnetische Beschichtung sein. Abhängig von der physikalischen Einflussgröße, einer zu erfassenden Temperatur, eines elektrischen Feldes oder eines Magnetfeldes, erfährt das funktionale Element eine Kraft und bewirkt eine Auslenkung des Stegs (ST, SE, SM). Mittels einer optischen Koppelstelle im optischen Wellenleiter (OF) zwischen dem mechanisch auslenkbaren Steg (ST, SE, SM) und dem optischen Empfänger (RX), welche im Auslenkungsfall des Stegs (ST, SE, SM) nur für eine reduzierte optische Leistung passierbar ist, korreliert das optische Empfangssignal mit der physikalischen Einflussgröße.

## Beschreibung

Die Erfindung betrifft einen Sensor und ein Verfahren zur Erfassung einer physikalischen Einflussgröße mit wenigstens einem optischen Sender und wenigstens einem optischen Empfänger. Des Weiteren betrifft die Erfindung ein Herstellungsverfahren für einen optischen Sensor sowie ein elektrisches Bauteil mit einem optischen Sensor.

### Stand der Technik

Die Erfassung physikalischer Einflussgrößen in elektrischen Bauteilen, wie elektrischer Strom, elektrische Spannung oder Temperatur, ist eine wichtige Aufgabe für unterschiedliche Anwendungsfelder, beispielsweise in der industriellen Automatisierung oder auch der Gebäudetechnik. Insbesondere in der industriellen Automatisierung, sei es in Schaltanlagen oder kleiner dimensioniert auf Leiterplatten wird es zunehmend wichtiger stromführende Bauteile überwachen zu können.

Nun existieren elektrische Geräte und Anwendungen, in denen es erforderlich ist, eine derartige Erfassung physikalischer Einflussgrößen, wie beispielsweise eine elektrische Strommessung, die Erfassung einer elektrischen Spannung beziehungsweise eines elektrischen Feldes oder die Erfassung einer Temperatur beziehungsweise eines Temperaturanstiegs derart zu gestalten, dass eine zuverlässige galvanische Trennung gewährleistet wird. Dies ist insbesondere in Leistungselektronikanwendungen der Fall.

Eine elektrische Strommessung in einer Leistungselektronikbaugruppen beispielsweise, erfordert eine sichere galvanische Trennung von Leistungs- und Steuerseite. Die Entkopplung des Sensors von der Steuerseite erfolgt bisher beispielsweise durch induktive beziehungsweise kapazitive Koppler, etwa sogenannte Ringkernwandler. Diese Technologien sind aufwändig und kostenintensiv. Zudem sind sie schwer bis unmöglich miniaturisierbar und daher nicht einfach in Bauteile verbaubar oder gar integrierbar. Eine direkte Messung in direkter Umgebung eines zu überwachenden Gerätes, Moduls oder Leistungshalbleiters ist damit nicht möglich. Aktuell erfolgt eine Strommessung für kleinere Leistungen beispielsweise über Shuntwiderstände und für größere und große Ströme über Ringkernwandler, nach dem Transformatorprinzip.

Für Anlagen der Energieverteilungstechnik werden beispielsweise kommerziell verfügbare optische Sensoren eingesetzt, welche auf dem Faradayeffekt beruhen. Diese Sensoren erfordern einen großen Bauraum und sind für den Feldeinsatz am Umspannmast vorgesehen. Demnach ist auch diese Technologie zu kostenintensiv und vor allem zu schwer bis unmöglich miniaturisierbar und nicht in Bauteile verbaubar oder integrierbar.

Zudem sind berührende Verfahren zur Strommessung bekannt, welche aber eben die Anforderung der sichere galvanische Trennung nicht erfüllen. Berührendes Verfahren heißt, dass ein physischer Kontakt zum Messobjekt hergestellt werden muss, um eine direkte Messung im Stromkreis vorzunehmen. Hierzu müsste also eine Messvorrichtung entweder fest integriert sein oder alternativ die Isolation der zu messenden elektrischen Leitung unterbrochen, d. h. beschädigt werden. Dieser notwendige direkte physische Kontakt zur stromführenden Leitung hat insbesondere bei Bestandsanlagen den Nachteil, dass diese Verfahren zur Vornahme einer Messung oder zur Installation zwischenzeitlich vom Netz getrennt werden müssen und im späteren Betrieb strenge Sicherheitsanforderungen eingehalten werden müssen, was die elektrische Sicherheit betrifft. Auch für die Datenübertragung muss eine galvanische Trennung realisiert werden.

Unter einem berührungslosen Verfahren wird ein Verfahren bzw. eine Vorrichtung angesehen oder verstanden, welche mit dem zu vermessenden elektrischen Leiter galvanisch getrennt angeordnet ist. Das heißt die Messung an dem elektrischen Leiter wird dadurch vorgenommen, dass das elektrische Feld oder das elektromagnetische Feld, welches von einem stromdurchflossenen Leiter oder Bauteil ausgeht, mittels eines Sensors erfasst wird. Unter galvanisch getrennt ist also zu verstehen, dass es zwar eine Potentialauswirkung gibt, also dass das elektrische Feld oder ein elektromagnetisches Feld von einem Sensor erfasst werden kann, aber es liegt eine elektrische Isolation vor, so dass kein Strom zwischen der zu vermessenden Leiter und der Vorrichtung, insbesondere der Messvorrichtung, fließen kann.

Ausgehend vom zuvor beschriebenen Stand der Technik liegt der Erfindung die Aufgabe zugrunde eine verbesserte Vorrichtung und ein Herstellungsverfahren dafür, sowie ein verbessertes Verfahren zur Erfassung einer physikalischen Einflussgröße anzugeben, sowie ein verbessertes elektrisches Bauteil.

Diese Aufgabe wird durch die Merkmale des unabhängigen Patentanspruchs 1 gelöst. Die auf das Verfahren bezogene Aufgabe wird durch die Merkmale des Patentanspruchs 11 gelöst. Ein Herstellungsverfahren ist in Patentanspruch 12 angegeben. Die auf ein elektrisches Bauteil bezogene Aufgabe wird durch die Merkmale des Patentanspruchs 15 gelöst. Vorteile und Ausgestaltungen der Erfindung, die einzeln oder in Kombination miteinander einsetzbar sind, sind Gegenstand der Unteransprüche. In den Unteransprüchen sind weitere vorteilhafte Maßnahmen aufgelistet, die beliebig miteinander kombiniert werden können, um weitere Vorteile zu erzielen.

### Beschreibung der Erfindung

Der erfindungsgemäße Sensor zur Erfassung einer physikalischen Einflussgröße, weist wenigstens einen optischen Sender und wenigstens einen optischen Empfänger sowie eine Anordnung wenigstens eines optischen Wellenleiter zwischen optischem Sender und optischem Empfänger auf. Der optische Wellenleiter ist mit einem funktionalen Element auf einem mechanisch auslenkbaren Steg angeordnet, welches funktionale Element abhängig von der physikalischen Einflussgröße eine Auslenkung des Stegs bewirkt. Des Weiteren weist der Sensor eine optische Koppelstelle im optischen Wellenleiter auf, zwischen dem mechanisch auslenkbaren Steg und dem optischen Empfänger. Diese optische Koppelstelle ist im Auslenkungsfall des Stegs nur für eine reduzierte optische Leistung passierbar. Durch die Auslenkung verändert sich die optische Dämpfung an der Koppelstelle zwischen flexiblem Steg und optischem Empfänger. Die Änderung der optischen Leistung wird am Empfänger gemessen.

Dieser Sensor hat den Vorteil vielseitig einsetzbar zu sein. Erfassbare physikalische Größen sind Magnetfeld, elektrisches Feld, Temperaturgradient und mechanische Erschütterung. Auf Grund des optischen Messverfahrens in Verbindung mit einem einfachen flachen Aufbau ist er miniaturisierbar und demnach gut integrierbar. Zudem sind derartige berührungslose Messverfahren von großem Vorteil für den Einsatz in bestehenden Systemen, weil diese leicht ohne baulichen Eingriff mit einer Messvorrichtung nachgerüstet werden können.

In einer vorteilhaften Ausführungsform der Erfindung dient der erfindungsgemäße Sensor zur Erfassung eines magnetischen Feldes und weist dazu einen optischen Empfänger und einen mechanisch auslenkbaren Steg auf, auf dem ein optischer Wellenleiter mit einem dauer- oder ferromagnetischen Element angeordnet sind. Eine dauer- oder ferromagnetische Schicht ist magnetfeldsensitiv und erfährt im Magnetfeld eines stromdurchflossenen Leiters eine Kraft, mittels der der bewegliche Steg ausgelenkt wird.

Das Magnetfeld bewirkt eine Ausrichtung der magnetischen Domänen innerhalb eines ferromagnetischen Materials. Diese Domänen sind Bereiche, in denen die magnetischen Momente der Atome parallel ausgerichtet sind. Bei Anlegen eines Magnetfeldes richten sich diese Domänen entlang des Feldes aus, was zu einer Änderung der interatomaren Abstände führt. Ein mit einer ferromagnetischen Schicht versehener optischer Wellenleiter wird daduch verformt, beziehungsweise bewegt.

Besonders die Realisierung einer berührungslosen und passiven Strommessung mittels optischem Verfahren hat große Vorteile für den Einsatz des Sensors in bestehenden Anlagen zur Nachrüstung sowie für alle Bereiche der Leistungselektronik, da eine galvanische Trennung gewährleistet ist. Gemessen wird die Veränderung der Lichtintensität und schließlich über eine Kalibrierfunktion die Stromstärke ermittelt.

In einer besonders vorteilhaften Ausführungsform der Erfindung weist der erfindungsgemäße Sensor wenigstens einen weiteren optischen Empfänger sowie eine Anordnung wenigstens eines weiteren optischen Wellenleiters auf, welcher optische Wellenleiter über einen nicht-auslenkbaren Steg mit diesem weiteren optischen Empfänger verbunden ist.

Dies hat den Vorteil, dass eine Referenzmessung erfolgen kann. Die Messung des optischen Signals, dass über den starren, nicht-beweglichen Steg zum Empfänger gelangt dient insbesondere dazu, Intensitätsänderungen auf der Senderseite festzustellen, so zu sagen zur Überwachung der optischen Leistung der Lichtquelle, also des Transmitters.

Bei mehreren optischen Wellenleitern dient bevorzugt ein optischer Splitter dazu das vom optischen Sender ausgesendete Signal auf die mehreren optischen Fasern zu verteilen, so zu sagen aufzusplitten.

Unter einem optischen Wellenleiter ist im Kontext der Anmeldung eine optische Faser, zum Beispiel eine Glasfaser zu verstehen, aber auch in Glassubstrate eingebrachte Wellenleiter können optische Signale, insbesondere Licht transportieren.

Unter einem optischen Sender ist insbesondere ein Gerät zu verstehen, das elektrische Signale in Lichtsignale umwandelt. Dies geschieht typischerweise mit Laserdioden oder Leuchtdioden. Der Sender koppelt das Licht in einen optischen Wellenleiter ein.

Ein optischer Splitter ist beispielsweise ein passives optisches Bauelement, das das Lichtsignal aus einem optischen Wellenleiter auf mehrere Ausgangsfasern aufteilt.

Unter einem optischen Empfänger ist insbesondere ein Gerät zu verstehen, das Lichtsignale aus einem optischen Wellenleiter in elektrische Signale umwandelt. Er besteht typischerweise aus einer Fotodiode, die das Licht detektiert und in einen elektrischen Strom umwandelt, und einer nachgeschalteten Elektronik zur Signalverarbeitung. Optische Empfänger sind das Gegenstück zu optischen Sendern und vervollständigen den Übertragungspfad eines optischen Signals.

In einer weiteren vorteilhaften Ausführungsform der Erfindung ist der erfindungsgemäße Sensor zur Erfassung einer Erschütterung geeignet, wozu er wenigstens einen weiteren optischen Empfänger sowie eine Anordnung wenigstens eines weiteren optischen Wellenleiters mit einem weiteren mechanisch auslenkbaren Steg aufweist. Dieser Steg weist kein zusätzliches funktionales Element auf. Er dient zur Erschütterungsmessung beziehungsweise zur Erfassung von Vibrationen. Dieser Sensor hat den Vorteil, dass auch der Einfluss von mechanischen Störgrößen wie z.B. Schwingungen zusätzlich berücksichtigt wird. Mittels des vorgeschlagenen Sensors kann eine Messung von Vibrationen, deren Schwingungsfrequenz und Amplitude erfolgen. Diese Messung kann auch als Referenzsignal zur Kalibration der Strombeziehungsweise Magnetfeldmesswerte sowie der noch nachstehend beschriebenen Messvarianten herangezogen werden.

In einer weiteren vorteilhaften Ausführungsform der Erfindung ist der erfindungsgemäße Sensor zur Erfassung eines elektrischen Feldes geeignet und weist dazu wenigstens einen weiteren optischen Empfänger sowie eine Anordnung wenigstens eines weiteren optischen Wellenleiters mit einem ferroelektrischen Element auf einem weiteren mechanisch auslenkbaren Steg auf.

Diese Ausführung des Sensors hat den Vorteil eine elektrische Potentialmessung beziehungsweise die Erfassung eines elektrischen Feldes zu ermöglichen. Dies kann Rückschlüsse auf Spannungen, insbesondere Spannungspeaks oder Überspannungen in einem zu überwachenden elektrischen Bauteil ermöglichen.

Ein ferroelektrisches Material reagiert mechanisch auf Änderungen eines elektrischen Feldes durch den sogenannten piezoelektrischen Effekt. Tritt der piezoelektrische Effekt auf, entwickelt das Material mechanische Spannungen und verformt sich, wenn es einem elektrischen Feld ausgesetzt wird. Dies geschieht, weil die Polarisation im Material eine Verschiebung der atomaren Positionen bewirkt, was zu einer makroskopischen Deformation führt. Diese mechanische Verformung ist reversibel und proportional zur Stärke des angelegten elektrischen Feldes. Diese mechanische Reaktion auf elektrische Felder wird im vorgeschlagenen Sensor für die Auslenkung einer optischen Faser genutzt. Mittels Kalibrierfunktion kann aus der verminderten optischen Intensität am Empfänger auf die Stärke des elektrischen Feldes geschlossen werden.

In einer weiteren vorteilhaften Ausführungsform der Erfindung ist der Sensor zur Erfassung einer Temperaturänderung geeignet und weist dazu wenigstens einen weiteren optischen Empfänger sowie eine Anordnung wenigstens eines weiteren optischen Wellenleiters mit einem bimetallischen Element auf einem weiteren mechanisch auslenkbaren Steg auf.

Das bimetallische Element ist vorteilhafterweise ein Bimetallstreifen. Dieser besteht aus zwei fest miteinander verbundenen Metallschichten mit unterschiedlichen linearen Ausdehnungskoeffizienten. Bei einer Temperaturänderung dehnen sich diese Metalle unterschiedlich stark aus. Das Metall mit dem höheren Ausdehnungskoeffizienten dehnt sich stärker aus als das Metall mit dem niedrigeren Ausdehnungskoeffizienten. Da die beiden Metalle mechanisch verbunden sind, führt die unterschiedliche Ausdehnung zu einer mechanischen Verformung des Streifens, typischerweise einer Krümmung. Diese Verformung bei Temperaturänderungen kann zur mechanischen Auslenkung des Stegs genutzt werden.

In einer weiteren vorteilhaften Ausführungsform der Erfindung weist der Sensor ein Substrat auf, aus welchem ein Trägerrahmen für optischen Sender und wenigstens einen optischen Empfänger als auch der wenigstens eine Steg oder die Stege gebildet sind, wobei das Substrat ein Glaswafer ist.

Ein Glaswafer ist insbesondere eine dünne Scheibe aus Glas, wie sie in der Mikro- und Nanotechnologie sowie in der Halbleiterfertigung als Substratmaterial verwendet wird. Bevorzugt wird ein Glaswafer aus hochreinem, spezialisiertem Glas eingesetzt.

Glaswafer sind besonders auf Grund ihrer optische Klarheit, also ihrer hohen Transparenz im sichtbaren und infraroten Spektralbereich, ideal für optische Anwendungen. Zudem weisen Glaswafer einen niedrigen thermischen Ausdehnungskoeffizienten auf und sind resistent gegenüber Temperaturschwankungen und Glaswafer haben hervorragende elektrische Isolationseigenschaften, was sie für die Verwendung in elektrischen und elektronischen Anwendungen prädestiniert.

In einer zur vorstehend beschriebenen Variante alternativen vorteilhaften Ausführungsform der Erfindung weist der Sensor ein Substrat auf, aus welchem ein Trägerrahmen für optischen Sender und wenigstens einen optischen Empfänger als auch der wenigstens eine Steg oder die Stege gebildet sind, wobei das Substrat eine Keramik oder einen Kunststoff umfasst.

Besonders geeignet würde der Sensor dann optischen Wellenleiter aus Lichtleitfasern aufweisen. Diese könnten auf das Trägersubstrat aus Keramik oder Kunststoff aufgebracht oder eingebracht werden. Zum Beispiel könnte eine Lichtleitfaser in einem mittels Spritzgussverfahrens hergestellten Kunststoffträgers eingebettet vorliegen.

In einer besonders vorteilhaften Ausführungsform der Erfindung basiert der Sensor auf einem Glaswafersubstrat und die optischen Wellenleiter sind direkt im Glaswafer eingebracht. Dies können besonders bevorzugt laserstrukturierte Wellenleiter sein.

Bei dem erfindungsgemäßen Verfahren zur Erfassung einer physikalischen Einflussgröße, wird zunächst ein optischer Wellenleiter mit einem funktionalen Element auf einem mechanisch auslenkbaren Steg angeordnet, wobei eine optische Koppelstelle im optischen Wellenleiter zwischen dem mechanisch auslenkbaren Steg und einem optischen Empfänger vorgesehen wird. Dies Koppelstelle ist im Auslenkungsfall des Stegs nur für eine reduzierte optische Leistung passierbar. Ein optischer Sender erzeugt ein optisches Signal und sendet es über den optischen Wellenleiter zu dem optischen Empfänger, wobei das funktionale Element abhängig von der physikalischen Einflussgröße eine Auslenkung des Stegs bewirkt.

Bei dem erfindungsgemäßen Herstellungsverfahren für einen erfindungsgemäßen Sensor wird wenigstens ein optischer Wellenleiter zwischen einem optischem Sender und einem optischem Empfänger angeordnet, wobei der optische Wellenleiter mit einem funktionalen Element auf einem mechanisch auslenkbaren Steg angeordnet wird, und bei dem eine optische Koppelstelle im optischen Wellenleiter erzeugt wird.

In einer besonders vorteilhaften Variante des erfindungsgemäßen Herstellungsverfahrens wird in einen Glaswafer der wenigstens eine optische Wellenleiter mittels Femtosekunden-Laserstrukturierung eingebracht.

Insbesondere wird bei einer Laserstrukturierung eines Glaswafers ein Laserstrahl verwendet, um präzise Muster oder Strukturen auf oder in der Glasoberfläche zu erzeugen. Dieser Prozess nutzt die Energie des Laserstrahls, um Material lokal zu schmelzen, verdampfen oder abtragen, wodurch definierte geometrische Formen entstehen.

Bei der Femtosekunden-Laserstrukturierung wird durch ultrakurz gepulste Laserstrahlung Brechungsindexmodifikationen im Glassubstrat erzeugt. Mit diesem Verfahren können optische Wellenleiter im Volumen des Glassubstrates erzeugt werden.

Dieses Verfahren wäre besonders vorteilhaft, da die Prozessierung der Glaswafer im Großmaßstab erfolgen kann. Die Verarbeitungstechniken sind geläufig und gleichzeitig präzise. Zudem wären die so hergestellten Sensoren in Leiterplatten integrierbar, einpressbar oder alternativ könnten zusätzlich bei der Bestückung einer Leiterplatte zur Baugruppenherstellung berücksichtigt werden.

In einem alternativen Herstellungsverfahren wird in den Glaswafer der wenigstens eine optische Wellenleiter mittels Ionenimplantation eingebracht. Dies erfolgt in einem nasschemischen Verfahren.

Der Vorteil der lonenimplantation läge insbesondere darin, dass dieser Prozess skalierbar ist, das heißt auch für große Stückzahlen realisierbar.

Das erfindungsgemäße elektrisches Bauteil weist einen erfindungsgemäßen Sensor auf, welcher bevorzugt im elektrischen Bauteil, insbesondere auf oder in der Leiterplatte integriert ist. Eine Ausführung als Bauelement ist realisierbar. Der Sensor ist bestückbar wie ein gängiges SMD-Bauteil (surface mounted device) oder in die Leiterplatte integrierbar, insbesondere bei Ausführung mit einem Dünnglas-Substrat.

Der vorgeschlagene Sensor ist von besonderem Vorteil für den Einsatz in elektrischen, elektronischen und insbesondere leistungselektronischen Bauteilen. Es wird ein miniaturisierbares optisches Sensorelement vorgeschlagen, welches zur Messung von Magnetfeld, elektrischem Feld, Temperatur, Schwingung sowie Störungskompensation geeignet ist. Damit sind auf der Leistungsseite keinerlei elektrischen Komponenten notwendig, auch keine Energieversorgung, da zur Detektion nur das durch das Sensorelement transmittierte Licht ausgewertet wird. Dieses Licht kann einfach und sicher zum Beispiel mittels Lichtleitfaser mit der Steuerseite verbunden werden. Es sind keine zusätzlichen Trennvorrichtungen notwendig. Die galvanische Trennung zwischen Sensor und Auswerteeinheit ist durch den Lichtleiter gewährleistet, sei es eine Lichtleitfaser oder ein strukturierter integrierter Wellenleiter. Die vorgeschlagene Lösung ermöglicht die Bestimmung der zentralen Parameter, die beim Betrieb von Leistungselektronikbaugruppen wichtig sind: Strom, Spannung, Temperatur und Vibration mit nur einem Sensorelement.

Der vorgeschlagene Sensor hat zudem keinen störenden Einfluss auf ein Schaltverhalten eines Bauteils, daher ist eine Chip-nahe Positionierung möglich. Der Sensor eröffnet neue Designfreiheitsgrade.

Auf Grund relativ kostengünstiger Herstellbarkeit ist eine Integration von vielen Einzelsensoren möglich, zum Beispiel zur Überwachung von Teilströmen auf einem Board.

Bei einer Volumenfertigung erscheinen neben den Vorteilen hinsichtlich Bauraum, Störfestigkeit und großer Designfreiheit auch Kostenvorteile möglich.

Durch das Miniaturisierungspotential kann auch die Effizienz erhöht werden.

### Figurenbeschreibung

Im Folgenden wird die Erfindung anhand der in den Figuren dargestellten Ausführungsbeispiele näher beschrieben. In den Ausführungsbeispielen und Figuren können gleiche oder gleich wirkende Elemente jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein. Merkmale, Eigenschaften und Vorteile der vorliegenden Erfindung werden in der nachfolgenden Beschreibung unter Bezugnahme auf die beiliegende Figuren erläutert. Darin zeigen schematisch:
- Figur 1: zeigt eine Draufsicht auf einen Sensor mit Trägerrahmen und fünf Stegen,
- Figur 2: zeigt einen Ausschnitt aus einer Seitenansicht einer Anordnung eines Sensorstegs mit einem stromdurchflossenen elektrischen Leiter.

Obwohl die Erfindung im Detail durch bevorzugte Ausführungsbeispiele näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die Patentansprüche definiert wird, zu verlassen.

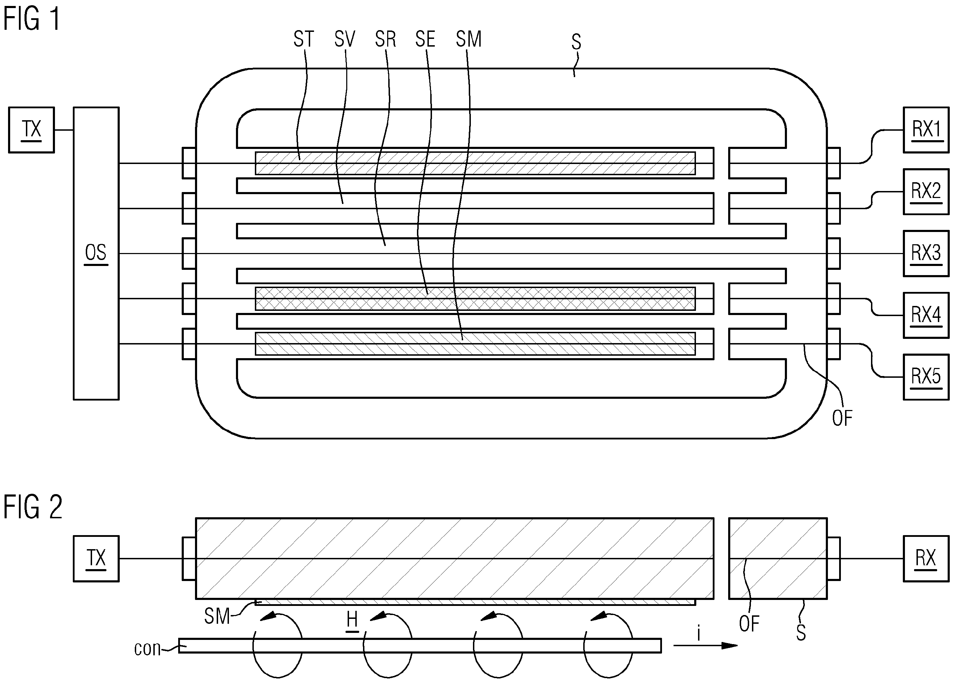

Die Figur 1 verdeutlicht den Aufbau und die Funktionsweise einer Ausführungsvariante eines Sensors zur Erfassung eines Magnetfeldes, eines elektrischen Feldes, eines Temperaturgradienten, einer mechanischen Erschütterung sowie eines Referenzsignals. Dazu weist der dargestellte Sensor zunächst einen Trägerrahmen und fünf Sensorstege auf. In der Figur 1 verlaufen die Stege alle parallel zueinander. Trägerrahmen und Stege können mehrteilig ausgeführt und zusammengefügt sein, können aus Leiterplattensubstraten oder Keramikträgern gebildet werden. Bevorzugt, wie hier gezeigt, sind Trägerrahmen und Stege einteilig ausgeführt, zum Beispiel aus einem flächigen Substrat S ausgeschnitten oder ausgestanzt oder additiv gefertigt.

Es sind fünf optische Wellenleiter OF gezeigt, welche, von links nach rechts, von einem optischen Sender TX, zum Beispiel einem Transmitter, beziehungsweise einem daran anschließenden optischen Splitter OS, beginnend, je über einen der fünf Stege verlaufen und schließlich auf der dem Transmitter gegenüberliegenden Rahmenseite fünft optische Sensoren RX erreichen. Vier der fünf optischen Wellenleiter OF weisen je eine optische Koppelstelle auf, das heißt eine Unterbrechung des optischen Wellenleiters, so dass eine Auskopplung und anschließend wieder eine Einkopplung des optischen Signals in den optischen Wellenleiter erfolgt. Diese optischen Koppelstellen bilden die Trennung zwischen den optischen Wellenleitern OF, die auf den mechanisch auslenkbaren Stegen ST, SV, SE, SM verlaufen und den optischen Wellenleiterabschnitten OF, die das optische Signal noch bis an die optischen Empfänger RX1-5 leiten. Das Prinzip des vorgeschlagenen optischen Sensors besteht also darin, dass ein optisches Signal an einer Unterbrechung des optischen Leiters OF aus- und wieder eingekoppelt, so dass bei einer Auslenkung des beweglichen gelagerten Teils des optischen Leiters OF die optische Dämpfung an der Koppelstelle verändert wird. Die Änderung der optischen Leistung wird an einem der optischen Empfänger RX1-5 gemessen.

Die optischen Leiter OF können zum Beispiel mittels Polymer-Wellenleitern oder diskreten optischen Fasern realisiert werden. Polymer-Wellenleiter OF können beispielsweise in Leiterplattensubstraten S integriert werden. Diskrete Fasern OF können vorteilhaft auf mechanischen Trägern S befestigt werden, insbesondere auf Keramikträgern.

Alternativ können Trägerrahmen und Stege aus einem Glasträger, insbesondere einem Dünnglasträger, auch Glaswafer genannt, gebildet sein. Aus Dünnglas kann eine gewünschte Struktur herausgeschnitten werden. Die gezeigte Struktur beinhaltet mehrere Stege ST, SV, SE, SM, SR, welche jeweils eine optische Faser OF beinhalten. Zur Herstellung der optischen Wellenleiter OF in einem Dünnglassubstrat S existieren mehrere Verfahren, wie beispielsweise Laserdirektschreiben oder lonenimplantationsverfahren.

In der Abbildung stellen die beiden oberen und die beiden unteren Stege, von links kommend, mechanisch flexible Arme dar. Der rechts gezeichnete Rahmen, in dem die optischen Fasern OF bis zu den Empfängern RX1-5 verlaufen, ist starr. Die dem Messobjekt zugewandte Seite der flexiblen Arme ist mit verschiedenen funktionalen Elementen versehen. Besonders geeignet sind funktionale Schichten beziehungsweise Beschichtungen. Der obere Steg ist der temperatursensitive Steg ST und weist eine bimetallische Schicht auf, der untere Steg ist der magnetfeldsensitive Steg SM und weist eine dauer- oder ferromagnetische Schicht auf und der darüber liegende Steg ist der E-Feld-sensitive Steg SE und weist eine ferroelektrischen Schicht auf. Der mittlere und der von oben gezählt zweite Steg sind unbeschichtet. Der mittlere Steg ist durchgängig von einer zur anderen Trägerrahmenseite, ohne Unterbrechung und demnach ohne Koppelstelle. Dieser ist der Referenzsteg. Der unbeschichtete Steg mit Koppelstelle ist der erschütterungssensitive Steg SV.

Bei Änderung der Temperatur erfährt der mit einer bimetallischen Schicht versehene Steg ST eine Auslenkung. Dadurch verändert sich die optische Dämpfung an der Koppelstelle zwischen flexiblem Arm und starrer optischen Faser OF. Die Änderung der optischen Leistung wird am Empfänger RX1 gemessen und bevorzugt mit einer geeigneten Messelektronik zur Bestimmung der Temperaturänderung verwendet.

Erfährt der Sensor mechanische Einflüsse, wie Schwingungen, Vibrationen oder sonstige Erschütterungen, so verursacht dies wiederum eine Änderung der optischen Dämpfung an der Koppelstelle im erschütterungssensitiven Steg SV. Diese Änderung der optischen Leistung wird am Empfänger RX2 gemessen und wird wiederum bevorzugt mit einer geeigneten Messelektronik zur Bestimmung der Schwingungsfrequenz bzw. Schwingungsamplitude verwendet. Das so erhaltene Signal wird vorteilhafterweise als Referenzsignal verwendet werden, um den Einfluss mechanischer Störgrößen auf die Messung von Temperatur, Magnetfeld und elektrischem Feld zu kompensieren.

Der Referenzsteg SR in der Mitte ist durchgängig und hat keine Koppelstelle. Er dient der Bestimmung eines Referenzsignals am Empfänger RX3 um insbesondere Schwankungen der Senderquelle TX zu kompensieren.

Bei Änderung des elektrischen Feldes erfährt der mit einer ferroelektrischen Schicht versehene Steg SE eine Auslenkung. Dadurch verändert sich wiederum die optische Dämpfung an der Koppelstelle zwischen flexiblem und starrem Empfänger RX4. Die Änderung der optischen Leistung wird am Empfänger RX4 gemessen und wieder wird mit einer geeigneten Messelektronik zur Bestimmung der elektrischen Feldstärke verwendet.

Bei Änderung des magnetischen Feldes erfährt der mit einer dauer- oder ferromagnetischen Schicht versehene Steg SM eine Auslenkung. Dadurch verändert sich die optische Dämpfung an der Koppelstelle zwischen flexiblem und starrer Einkoppelstelle des optischen Wellenleiters OF. Die Änderung der optischen Leistung wird am Empfänger RX5 gemessen und wird mit einer geeigneten Messelektronik zur Bestimmung der magnetischen Feldstärke verwendet. Aus der magnetischen Feldstärke können beispielsweise auch auf eine Stromstärke rückgeschlossen werden.

Bevorzugte Größenordnungen der vorgeschlagenen optischen Wellenleiter OF:
Bei Singlemode Fasern weisen die Glasfasern Kerndurchmesser von wenigen µm auf. Bei Multimode Fasern weisen die Glasfasern Kerndurchmessern im Bereich von 50 bis 200 µm auf. Bei polymeroptischen Fasern weisen die Polymerfasern Kerndurchmessern von typischerweise 1 mm. Bei in Glaswafer einstrukturierten Wellenleitern liegen die Durchmesser bevorzugt zwischen wenigen µm bis zu 200 µm.

Bevorzugte bauliche Größenordnungen der Stege liegen bei wenigen mm Breite und bevorzugt zwischen im Millimeterbereich bis zu wenige cm Länge. Besonders zweckdienlich sind Leiterplattendimensionen, das heißt dass der Sensor in eine Leiterplatte integriert vorliegt oder eine Leiterplatte in einer Baugruppe zusätzlich mit einem vorgeschlagenen Sensor bestückt wird.

Figur 2 schließlich dient noch zur Verdeutlichung der Funktionsweise: Wird die in obenstehend beschriebene und in Figur 1 gezeigte Sensorstruktur in die Nähe eines stromdurchflossenen Leiters con gebracht, zweckdienlicherweise so, dass der magnetfeldsensitive Steg SM parallel zum zu messenden elektrischen Leiter con angeordnet ist, bewirkt das Magnetfeld H des Leiters con eine lateral zur optischen Achse wirkende Auslenkung des mit der dauer- oder ferromagnetischen Schicht versehenen flexiblen Arms SM. Dadurch verändert sich die Koppeleffizienz an der optischen Koppelstelle zwischen den beiden Wellenleiterteilen, wodurch eine Intensitätsänderung auf der Empfängerseite RX5 messbar wird. Aus dieser Intensitätsänderung lässt sich insbesondere über geeignete Kalibrierfunktionen direkt auf den durch den Leiter con fließenden Strom I schließen.

Zusammenfassend wird festgehalten, dass ein Sensor und ein Verfahren zur Erfassung einer physikalischen Einflussgröße mit wenigstens einem optischen Sender und wenigstens einem optischen Empfänger vorgeschlagen wird. Des Weiteren wird ein Herstellungsverfahren für einen optischen Sensor sowie ein elektrisches Bauteil mit einem optischen Sensor vorgeschlagen. Der vorgeschlagene Sensor weist wenigstens einen optischen Sender und wenigstens einen optischen Empfänge auf, sowie eine Anordnung wenigstens eines optischen Wellenleiters zwischen optischem Sender und optischem Empfänger. Der optische Wellenleiter ist mit einem funktionalen Element auf einem mechanisch auslenkbaren Steg angeordnet. Das funktionale Element kann ein Bimetall, eine ferroelektrische Beschichtung oder eine magnetische Beschichtung sein. Abhängig von der physikalischen Einflussgröße, einer zu erfassenden Temperatur, eines elektrischen Feldes oder eines Magnetfeldes, erfährt das funktionale Element eine Kraft und bewirkt eine Auslenkung des Stegs. Mittels einer optischen Koppelstelle im optischen Wellenleiter zwischen dem mechanisch auslenkbaren Steg und dem optischen Empfänger, welche im Auslenkungsfall des Stegs nur für eine reduzierte optische Leistung passierbar ist, korreliert das optische Empfangssignal mit der physikalischen Einflussgröße.

### Bezugszeichenliste

- TX: Optischer Sender, Transmitter
- RX1-5: optischer Empfänger
- ST: Temperatursensitiver Steg
- SV: Vibrationsempfindlicher Steg
- SE: E-Feldsensitiver Steg
- SM: Magnetfeldsensitiver Steg
- SR: Referenzsteg
- OF: Optische Faser
- OS: Optischer Splitter
- S: Substrat, insbesondere Glaswafer
- con: elektrischer Leiter, stromdurchflossen
- I: Stromstärke
- H: Magnetfeldstärke

## Patentansprüche

1. Sensor zur Erfassung einer physikalischen Einflussgröße, aufweisend wenigstens einen optischen Sender (TX) und wenigstens einen optischen Empfänger (RX1, 4, 5) sowie eine Anordnung wenigstens eines optischen Wellenleiters (OF) zwischen optischem Sender (TX) und optischem Empfänger (RX1, 4, 5), welcher optische Wellenleiter (OF) mit einem funktionalen Element auf einem mechanisch auslenkbaren Steg (ST, SE, SM) angeordnet ist, welches funktionale Element abhängig von der physikalischen Einflussgröße eine Auslenkung des Stegs (ST, SE, SM) bewirkt und aufweisend eine optische Koppelstelle im optischen Wellenleiter (OF) zwischen dem mechanisch auslenkbaren Steg (ST, SE, SM) und dem optischen Empfänger (RX1, 4, 5), welche im Auslenkungsfall des Stegs (ST, SE, SM) nur für eine reduzierte optische Leistung passierbar ist.

2. Sensor nach Anspruch 1 zur Erfassung eines magnetischen Feldes, mit einem optischen Empfänger (RX5) und einem optischen Wellenleiter (OF) mit einem dauer- oder ferromagnetischen Element auf dem mechanisch auslenkbaren Steg (SM) angeordnet.

3. Sensor nach einem der vorstehenden Ansprüche, aufweisend wenigstens einen weiteren optischen Empfänger (RX3) sowie eine Anordnung wenigstens eines weiteren optischen Wellenleiters (OF) über einen nicht-auslenkbaren Steg (SR) mit diesem weiteren optischen Empfänger (RX3).

4. Sensor nach einem der vorstehenden Ansprüche zur Erfassung einer Erschütterung, aufweisend wenigstens einen weiteren optischen Empfänger (RX2) sowie eine Anordnung wenigstens eines weiteren optischen Wellenleiters (OF) mit einem weiteren mechanisch auslenkbaren Steg (SV).

5. Sensor nach einem der vorstehenden Ansprüche zur Erfassung eines elektrischen Feldes, aufweisend wenigstens einen weiteren optischen Empfänger (RX4) sowie eine Anordnung wenigstens eines weiteren optischen Wellenleiters (OF) mit einem ferroelektrischen Element auf einem weiteren mechanisch auslenkbaren Steg (SE).

6. Sensor nach einem der vorstehenden Ansprüche zur Erfassung einer Temperaturänderung, aufweisend wenigstens einen weiteren optischen Empfänger (RX1) sowie eine Anordnung wenigstens eines weiteren optischen Wellenleiters (OF) mit einem bimetallischen Element auf einem weiteren mechanisch auslenkbaren Steg (ST).

7. Sensor nach einem der vorstehenden Ansprüche, aufweisend ein Substrat (S) aus welchem ein Trägerrahmen für optischen Sender (TX) und wenigstens einen optischen Empfänger (RX1-5) als auch der wenigstens eine Steg oder die Stege (ST, SE, SM, SR, SV) gebildet sind, wobei das Substrat (S) ein Glaswafer ist.

8. Sensor nach einem der vorstehenden Ansprüche 1 bis 6, aufweisend ein Substrat (S) aus welchem ein Trägerrahmen für optischen Sender (TX) und wenigstens einen optischen Empfänger (RX1-5) also auch der wenigstens eine Steg oder die Stege (ST, SE, SM, SR, SV) gebildet sind, wobei das Substrat (S) eine Keramik oder einen Kunststoff umfasst.

9. Sensor nach einem der vorstehenden Ansprüche, wobei die optischen Wellenleiter (OF) aus Lichtleitfasern gebildet sind.

10. Sensor nach Anspruch 7, wobei die optischen Wellenleiter (OF) direkt im Glaswafer eingebracht sind.

11. Verfahren zur Erfassung einer physikalischen Einflussgröße, bei dem zunächst ein optischer Wellenleiter (OF) mit einem funktionalen Element auf einem mechanisch auslenkbaren Steg (ST, SE, SM) angeordnet wird, wobei eine optische Koppelstelle im optischen Wellenleiter (OF) zwischen dem mechanisch auslenkbaren Steg (ST, SE, SM) und einem optischen Empfänger (RX1, 4, 5) vorgesehen wird, welche im Auslenkungsfall des Stegs (ST, SE, SM) nur für eine reduzierte optische Leistung passierbar ist, und bei dem ein optischer Sender (TX) ein optisches Signal erzeugt und über den optischen Wellenleiter (OF) zu dem optischen Empfänger (RX1, 4, 5) sendet, wobei das funktionale Element abhängig von der physikalischen Einflussgröße eine Auslenkung des Stegs (ST, SE, SM) bewirkt.

12. Herstellungsverfahren für einen Sensor nach einem der vorstehenden Ansprüche 1 bis 11, bei dem wenigstens ein optischer Wellenleiter (OF) zwischen einem optischem Sender (TX) und einem optischem Empfänger (RX1, 4, 5) angeordnet wird, wobei der optische Wellenleiter (OF) mit einem funktionalen Element auf einem mechanisch auslenkbaren Steg (ST, SE, SM) angeordnet wird, und bei dem eine optische Koppelstelle im optischen Wellenleiter (OF) erzeugt wird.

13. Herstellungsverfahren nach Anspruch 12 für einen Sensor nach Anspruch 8 und 11, wobei in den Glaswafer (S) der wenigstens eine optische Wellenleiter (OF) mittels Femtosekunden-Laserstrukturierung eingebracht wird.

14. Herstellungsverfahren nach Anspruch 12 für einen Sensor nach Anspruch 8 und 11, wobei in den Glaswafer (S) der wenigstens eine optische Wellenleiter (OF) mittels lonenimplantation eingebracht wird.

15. Elektrisches Bauteil mit einem Sensor nach einem der vorstehenden Ansprüche 1 bis 11.
